# EUROPEAN PATENT APPLICATION

(11) **EP 4 195 239 A1**
(43) Date of publication of application: **14.06.2023**
(21) Application number: 20950827.4
(22) Date of filing: 28.08.2020
(51) Int. Cl.: H01L 21/20, H01L 29/778, C30B 29/36

(54) **SUBSTRATE AND POWER AMPLIFICATION DEVICE**

(71) Applicant: Huawei Technologies Co., Ltd., Shenzhen, Guangdong 518129 (CN)
(72) Inventor: HU, Bin, Shenzhen, Guangdong 518129 (CN); DUAN, Huantao, Shenzhen, Guangdong 518129 (CN)
(74) Representative: Epping - Hermann - Fischer
(86) International application number: PCT/CN2020/112292
(87) International publication number: WO 2022/041157

(57) **Abstract**

Embodiments of this application provide a substrate and a power amplification component, and relate to the field of semiconductor technologies, so that a new composite substrate is implemented, dependence of a transistor on a silicon carbide semiconductor substrate is reduced, and costs are effectively controlled. The substrate is used in a transistor, and an epitaxial structure of the transistor is generated on the substrate. The substrate includes a base and a first epitaxial layer formed on the base. The first epitaxial layer is a semiconductor, the base and the first epitaxial layer include a SiC material, and the first epitaxial layer is doped with transition metal.

## Description

### TECHNICAL FIELD

This application relates to the field of semiconductor technologies, and in particular, to a substrate and a power amplification component.

### BACKGROUND

A high-electron-mobility transistor (high-electron-mobility transistor, HEMT) is a power amplification component mainly used in an electronic device. For example, power of a radio frequency signal generated in a radio frequency modulation circuit of the electronic device is extremely low, and the radio frequency signal power needs to be amplified in series to obtain enough radio frequency power before being fed to an antenna for radiation. To obtain high enough radio frequency power, a radio frequency power amplifier needs to be used to amplify the power of the radio frequency signal. The radio frequency power amplifier is widely used in a device in a system such as a radar, wireless communication, navigation, satellite communication, or electronic countermeasure, and is a key component in modern wireless communication.

In a conventional third-generation/fourth-generation mobile communication technology (3rd-generation of wireless communications technologies, 3G)/4G era, the radio frequency power amplifier is a component based on a silicon (Si) or gallium arsenide (GaAs) material. In a 5G era, a gallium nitride (GaN)-based high-electron-mobility transistor is widely used in a device such as a base station due to a characteristic of high performance. The gallium nitride-based HEMT is generally fabricated on a high-purity silicon carbide substrate through epitaxial growth.

Currently, a substrate is usually formed by using a silicon carbide SiC material, and a process of forming the substrate is mainly as follows: High-purity silicon carbide powder is used, and high-temperature sublimation is performed in a temperature condition of more than 2000°C by using a physical vapor transport (physical vapor transport process, PVT) method, to obtain a SiC crystal, and a growth environment (nitrogen in air needs to be isolated) of relatively high purity needs to be maintained in a process of growing the SiC crystal. Then, processing such as wire cutting, grinding, and polishing is performed on the SiC crystal to obtain the silicon carbide substrate. The high-purity silicon carbide powder is obtained after high-purity carbon powder and high-purity silicon powder are purified and react with each other, and has a high requirement for purity of a material. The purity of the material usually needs to be higher than 99.999%. The substrate fabricated in this way is an intrinsic semiconductor (or a semiconductor in an intrinsic state), resistivity of the substrate is greater than 1e5 Ω·cm (Ohm·centimeter), and thickness is 500 µm ± 25 µm. In the foregoing process, growth of the SiC crystal and a processing process of the substrate are complex, and strict conditions are required, and consequently, costs of the substrate are extremely high, and costs of a component are also high. Therefore, application of the HEMT component in a larger range is limited. In addition, a silicon carbide semiconductor substrate is mainly 100 mm (4 inches) in size. There is a technical challenge to further expand the size to 150 mm (6 inches) and 200 mm (8 inches), and costs are even higher.

### SUMMARY

This application provides a substrate and a power amplification component, to implement a new composite substrate, reduce dependence of a transistor on a silicon carbide semiconductor substrate, and effectively control costs.

According to a first aspect, a substrate is provided. The substrate is used in a transistor such as a HEMT, and an epitaxial structure of the transistor is generated on the substrate. The substrate includes a base and a first epitaxial layer formed on the base. The first epitaxial layer is a semiconductor, the base and the first epitaxial layer include a SiC material, the first epitaxial layer is doped with transition metal, and the base is doped with an impurity that provides a carrier. In the foregoing solution, the substrate may use at least two layers of materials, that is, the base and the first epitaxial layer. The base mainly uses the SiC material and is doped with the impurity that provides the carrier, and the first epitaxial layer uses a SiC material doped with the transition metal. In this way, because the first epitaxial layer uses the SiC material doped with the transition metal, and impurity compensation is performed on the SiC material by using the transition metal, resistivity of the first epitaxial layer can be improved, so that the first epitaxial layer has a semi-insulator characteristic, and a fabrication requirement on an epitaxial structure is met. Because the epitaxial structure is not directly fabricated on the base, a requirement on the base is reduced in this embodiment of this application. Therefore, dependence of the transistor on a silicon carbide substrate in an intrinsic state is reduced, and costs are effectively controlled. For example, in this embodiment of this application, the SiC material is used to form the base, and a silicon carbide material doped with the transition metal is used to form the first epitaxial layer with the semi-insulator characteristic. Compared with a conventional technology in which only the silicon carbide material is used to form the silicon carbide substrate in the intrinsic state, the substrate in this application uses a form of a composite substrate with the base and the first epitaxial layer, so that a quantity of used silicon carbide materials in the intrinsic state can be reduced. The base may use a conductive silicon carbide material doped with the impurity that can provide the carrier. In this way, a requirement on a growth process is much lower than that of the silicon carbide substrate in the intrinsic state. For example, the base may be a conductive SiC material (that is, doped with the impurity that can provide the carrier). In this way, resistivity of the first epitaxial layer is greater than resistivity of the base. Because a resistivity requirement on the base is relatively low, requirements on purity and doping of silicon carbide powder are relatively low in a process of fabricating the base. For example, the base uses an N-type substrate (doped with an N-type element) with relatively low fabrication costs. In this way, when SiC powder is used to form a SiC crystal, there is no need to entirely isolate air, and no requirement is imposed on impurities such as nitrogen N, aluminum Al, and boron B that can provide the carrier and that are introduced in a production process due to unintentional doping.

In a possible implementation, a second epitaxial layer is included between the first epitaxial layer and the base, the second epitaxial layer includes the SiC material, and the second epitaxial layer and the base are formed by using different processing processes. When two or more epitaxial layers are used, and at least the second epitaxial layer is included between the first epitaxial layer and the base, the transition metal needs to be doped only on a top epitaxial layer (such as the first epitaxial layer), so that the thickness of the first epitaxial layer can be reduced as much as possible. A requirement on the second epitaxial layer is similar to that on the base, so that a quantity of used silicon carbide materials in the intrinsic state can be further reduced. In addition, the second epitaxial layer and the base are formed by using different processing processes. For example, the base mainly grows by using silicon carbide powder by using a physical vapor transport (physical vapor transport process, PVT) method, to obtain the SiC crystal, and then, processing such as wire cutting, grinding, and polishing is performed on the SiC crystal to obtain the base. Because the base may use a conductive base, requirements on purity of the silicon carbide powder and process complexity of the PVT are relatively low. Then, the second epitaxial layer is epitaxially formed on the base through high-temperature chemical vapor deposition (chemical vapor deposition, CVD).

In a possible implementation, the second epitaxial layer may use the conductive silicon carbide material or the silicon carbide material with the semi-insulator characteristic. For example, when two or more epitaxial layers are used, the transition metal needs to be doped only on the top epitaxial layer (such as the first epitaxial layer) to form the silicon carbide material with the semi-insulator characteristic, and an epitaxial layer (such as the second epitaxial layer) in the middle uses the conductive silicon carbide material. In this way, the thickness of the first epitaxial layer can be reduced as much as possible, so that an amount of transition metal used during doping is reduced, and occurrence of a crystal defect and a crystal polytype problem is also reduced. Alternatively, the second epitaxial layer may be a silicon carbide material that has the semi-insulator characteristic and that is formed by doping the transition metal (such as vanadium V or iron Fe) by using reactant gas in an epitaxial growth process.

In a possible implementation, the resistivity of the first epitaxial layer is greater than the resistivity of the base. For example, the resistivity of the first epitaxial layer is greater than 1e5 Ω·cm, and the resistivity of the base is less than 0.03 Ω·cm.

In a possible implementation, the resistivity of the second epitaxial layer is equal to the resistivity of the base, for example, the resistivity of the second epitaxial layer is less than 0.03 Q cm; or the resistivity of the second epitaxial layer is greater than the resistivity of the base and less than the resistivity of the first epitaxial layer. For example, the resistivity of the second epitaxial layer may be greater than or equal to 0.03 Qcm and less than 1e5 Ω·cm. In this way, gradual transition from the resistivity of the base to the resistivity of the first epitaxial layer can be implemented. Specifically, the resistivity may be adjusted by controlling doping concentration of the transition metal. In this way, when the doping concentration of the transition metal of the second epitaxial layer is less than that of the first epitaxial layer, the resistivity of the second epitaxial layer is less than the resistivity of the first epitaxial layer. In this way, occurrence of a crystal defect and a crystal polytype problem that are caused by an excessively large material property difference when the first epitaxial layer is directly fabricated on the base can also be avoided. In addition, the resistivity of the second epitaxial layer may also be adjusted by controlling a Si vacancy and/or a C vacancy in an epitaxy process of SiC.

In a possible implementation, the transition metal includes vanadium V or iron Fe. The first epitaxial layer is mainly implemented by doping the transition metal in a homogeneous epitaxial growth process through chemical vapor deposition CVD, and the transition metal includes vanadium V or iron Fe. When the transition metal vanadium V is doped, a proper amount of reactant gas (such as VCl₄) of a vanadium compound is specifically injected in the epitaxial growth process, so that the vanadium is doped. A vanadium impurity in the SiC crystal can be used as a compensation center of a deep energy level, and can compensate for unintentionally doped nitrogen N and boron B in the SiC crystal, to implement the semi-insulator characteristic of the first epitaxial layer. In addition, it should be noted that, when the transition metal iron is doped, a proper amount of reactant gas (such as tert-Butylferrocene C₁₄H₁₇Fe) of an iron compound is specifically injected in the epitaxial growth process, so that the iron is doped.

In a possible implementation, doping concentration of the transition metal in the first epitaxial layer 312 is 1e14 cm^-3 to 1e17 cm^-3.

In a possible implementation, the thickness of the first epitaxial layer is 1 µm to 100 µm. When the substrate includes only the base and the epitaxial layer, thickness of the base is 350 µm ± 25 µm, and the thickness of the first epitaxial layer is 1 µm to 100 µm, so that thickness of the substrate can meet a requirement on an epitaxial structure of an epitaxial transistor.

In a possible implementation, the thickness of the first epitaxial layer is 1 µm to 50 µm, and thickness of the second epitaxial layer is 1 µm to 50 µm. When the substrate includes only the base and at least two epitaxial layers, thickness of the two epitaxial layers may be reduced to 1 µm to 50 µm, to reduce the thickness of the top first epitaxial layer as much as possible.

In a possible implementation, a unit cell of the SiC material uses a 4H structure.

According to a second aspect, a fabrication method for a substrate is provided. The substrate is used in a transistor, an epitaxial structure of the transistor is generated on the substrate, and the fabrication method includes: performing surface processing on a surface of the base; and fabricating a first epitaxial layer on the base, where the base and the first epitaxial layer include a SiC material, the first epitaxial layer is doped with transition metal, and the base is doped with an impurity that provides a carrier.

In a possible implementation, before the fabricating a first epitaxial layer on the base, the method further includes: fabricating a second epitaxial layer on the base, where the second epitaxial layer includes the SiC material.

In a possible implementation, the surface processing includes one or more of cutting processing, grinding processing, and polishing processing. After surface processing is performed on the surface of the base, roughness of the surface of the base is less than or equal to 0.5 nm.

In a possible implementation, after the performing surface processing on a surface of the base, the method further includes: performing etching on the surface of the base to form steps of an atomic-level size. Width of the steps is 1 nm to 3 µm, and height is 0.25 nm to 2 nm.

In a possible implementation, the fabricating a first epitaxial layer on the base includes: epitaxially forming the first epitaxial layer on the base by using a chemical vapor deposition process.

In a possible implementation, gas used in the chemical vapor deposition process includes silane SiH₄, propane C₃H₈, and a transition metal compound.

In a possible implementation, the transition metal compound includes vanadium tetrachloride VCL₄ or tert-Butylferrocene C₁₄H₁₇Fe.

In a possible implementation, the fabricating a second epitaxial layer on the base includes: epitaxially forming the second epitaxial layer on the base by using the chemical vapor deposition process.

In a possible implementation, gas used in the chemical vapor deposition process includes SiH₄ and propane C₃H₈.

In a possible implementation, after the fabricating a second epitaxial layer on the base, the method further includes: performing one-time surface processing on the second epitaxial layer, so that roughness of a surface of the second epitaxial layer is less than 0.5 nm.

In a possible implementation, after the fabricating a first epitaxial layer on the base, the method further includes: performing one-time surface processing on the first epitaxial layer, so that roughness of a surface of the first epitaxial layer is less than 0.5 nm.

According to a third aspect, a power amplification component is provided, and includes a substrate and an epitaxial structure that is of a transistor and that is formed on the substrate, and the substrate includes the foregoing substrate. In a possible implementation, the epitaxial structure includes a buffer layer disposed on a first epitaxial layer and a barrier layer disposed on the buffer layer, and there is an electrode on the barrier layer.

In a possible implementation, the epitaxial structure further includes a nucleation layer disposed between the first epitaxial layer and the buffer layer.

In a possible implementation, the epitaxial structure further includes an insertion layer disposed between the buffer layer and the barrier layer.

According to a fourth aspect, an electronic device is provided, and includes a power amplification component and an antenna. The power amplification component is configured to amplify a radio frequency signal and output the radio frequency signal to the antenna for external radiation, and the power amplification component includes the foregoing power amplification component.

According to a fifth aspect, a non-transitory computer readable storage medium to be used together with a computer is provided. The computer has software used to design an integrated circuit, the computer readable storage medium stores one or more computer readable data structures, and a process device fabricates the foregoing provided substrate by using the one or more computer readable data structures.

For technical effects brought by any possible implementation of the second aspect to the fifth aspect, refer to technical effects brought by different implementations of the first aspect. Details are not described herein again.

### BRIEF DESCRIPTION OF DRAWINGS

FIG. 1 is a schematic diagram of a structure of a hexagonal crystal system according to an embodiment of this application;
FIG. 2 is a schematic diagram of a structure of a base station according to an embodiment of this application;
FIG. 3 is a schematic diagram of a structure of a base station according to another embodiment of this application;
FIG. 4 is a schematic diagram of a structure of a power amplification component according to an embodiment of this application;
FIG. 5 is a schematic diagram of a structure of a substrate according to an embodiment of this application;
FIG. 6 is a schematic diagram of a structure of a substrate according to another embodiment of this application;
FIG. 7 is a schematic diagram of a structure of a substrate according to still another embodiment of this application;
FIG. 8 is a schematic diagram of a structure of a substrate according to yet another embodiment of this application;
FIG. 9 is a flowchart of a fabrication method for a substrate according to an embodiment of this application;
FIG. 10 is a schematic diagram 1 of a structure of a substrate in a fabrication process according to an embodiment of this application;
FIG. 11 is a schematic diagram 2 of a structure of a substrate in a fabrication process according to an embodiment of this application;
FIG. 12 is a schematic diagram 3 of a structure of a substrate in a fabrication process according to an embodiment of this application; and
FIG. 13 is a schematic flowchart of a fabrication method for a substrate according to another embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

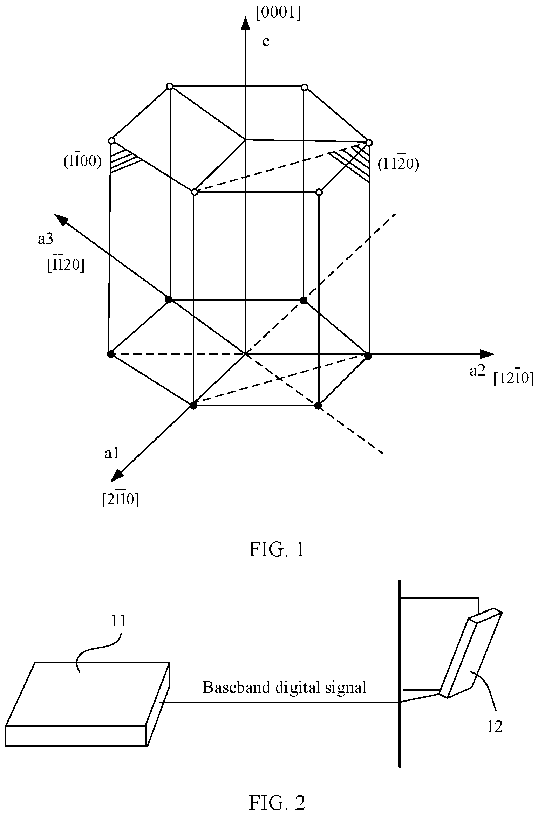

Technical terms in embodiments of this application are described as follows:
A hexagonal (hexagonal) crystal system is a crystal home of symmetric elements with a feature of a hexagonal axis or an inverted hexagonal axis in a principle axis direction of the unique c crystal axis that has a high-order axis. The hexagonal crystal system is also referred to as a "hexagonal galaxy" and belongs to an intermediate crystal family. As shown in FIG. 1, in the hexagonal crystal system, four crystal axes a1, a2, a3, and c are generally used to calibrate a crystal plane index and a crystal orientation index to reflect a crystal orientation and a crystal plane of an atom in the hexagonal crystal system. The crystal orientation is directions of a plurality of dot arrays in a space lattice (a direction of a straight-line connecting any node column in the lattice). In the hexagonal crystal system, the crystal orientation is used to indicate some directions in a crystal, and relates to a position of an atom in the crystal and a direction of an atom column, and identifies a direction of a group of parallel straight lines with consistent directions. The crystal plane is a plane that passes through any lattice point in the space lattice (a plane including nodes in the lattice). The crystal plane in the hexagonal crystal system is used to represent a plane including atoms in the crystal. In FIG. 1, a hexagonal crystal structure of SiC is used as an example, a crystal orientation of a c-axis is [0001], a crystal orientation of an a1-axis is [21̅1̅0], a crystal orientation of an a2-axis is [121̅0], and a crystal orientation of an a3 -axis is [1̅1̅20]. FIG. 1 further shows two crystal planes ( 1 1̅ 00) and ( 1 1 2̅ 0) . In FIG. 1, a white point is a Si atom, and a black point is a C atom.

Semiconductor: The semiconductor is a material whose electrical conductivity is between that of a conductor and that of an insulator at normal temperature, and the semiconductor includes an intrinsic semiconductor and an impurity semiconductor. In a pure semiconductor without impurities and defects, electron concentration and hole concentration are equal, and the pure semiconductor is referred to as the intrinsic semiconductor. A semiconductor doped with a specific quantity of impurities is referred to as the impurity semiconductor or a non-intrinsic semiconductor. When the impurity doped in the impurity semiconductor can provide a carrier (such as a hole or an electron, where an impurity semiconductor doped with an impurity (such as a phosphorus element whose valence is 5) that provides the electron is also referred to as an electronic semiconductor or an N (negative, negative)-type semiconductor, and an impurity semiconductor doped with an impurity that provides the hole (such as a boron element whose valence is 3) is also referred to as a hole-type semiconductor or a P (positive, positive)-type semiconductor), electrical conductivity of the intrinsic semiconductor can be improved. Generally, higher carrier concentration leads to lower resistivity of the semiconductor and better electrical conductivity. In this embodiment of this application, this type of impurity semiconductor is also referred to as a conductive semiconductor, such as a conductive silicon carbide material, and doped impurities are nitrogen N, boron B, and aluminum Al. In addition, when the impurity doped in the impurity semiconductor can perform impurity compensation on the impurity semiconductor, a donor electron exactly fills an acceptor level. However, the electron and the hole cannot be provided for a conduction band and a valance band, so that resistivity of a semiconductor material with a relatively wide forbidden band is close to that of an insulator. For example, in this embodiment of this application, the silicon carbide material is doped with the transition metal, to implement impurity compensation for the silicon carbide material, so that resistivity of the silicon carbide material is improved. Such an impurity semiconductor is also referred to as a semi-insulated semiconductor or a semi-insulator, or has a semi-insulator characteristic.

Unless otherwise defined, all scientific and technological terms used in this specification have same meanings as those known by a person of ordinary skills in the art. In this application, "at least one" means one or more, and "a plurality of" means two or more. "And/or" describes an association relationship between associated objects, and represents that three relationships may exist. For example, A and/or B may represent the following cases: Only A exists, both A and B exist, and only B exists, where A and B may be singular or plural. The character "/" usually indicates an "or" relationship between associated objects. "At least one of the following items (pieces)" or a similar expression thereof refers to any combination of these items, including any combination of singular items (pieces) or plural items (pieces). For example, at least one of a, b, or c may represent a, b, c, a and b, a and c, b and c, or a, b, and c, where a, b, and c may be single or multiple. In addition, in this embodiment of this application, words such as "first" and "second" do not limit a quantity and a sequence.

In addition, in this application, location terms such as "top" and "bottom" are defined relative to locations of parts schematically placed in the accompanying drawings. It should be understood that these directional terms are relative concepts and are used for relative description and clarification, and may be correspondingly changed based on changes in the locations of the parts schematically placed in the accompanying drawings.

It should be noted that, in embodiments of this application, the term such as "example" or "for example" is used to represent giving an example, an illustration, or descriptions. Any embodiment or design described as an "example" or "for example" in embodiments of this application should not be explained as being more preferred or having more advantages than another embodiment or design. Exactly, use of the word "example", "for example", or the like is intended to present a related concept in a specific manner.

Technical solutions of this application may be applied to an electronic device. The electronic device is different types of user equipment or terminal devices such as a computer, a mobile phone, a tablet computer, a wearable device, or a vehicle-mounted device. The electronic device may alternatively be a network device such as a base station. The electronic device may alternatively be an apparatus such as a power amplifier used in the foregoing electronic device. A specific form of the electronic device is not specifically limited in embodiments of this application.

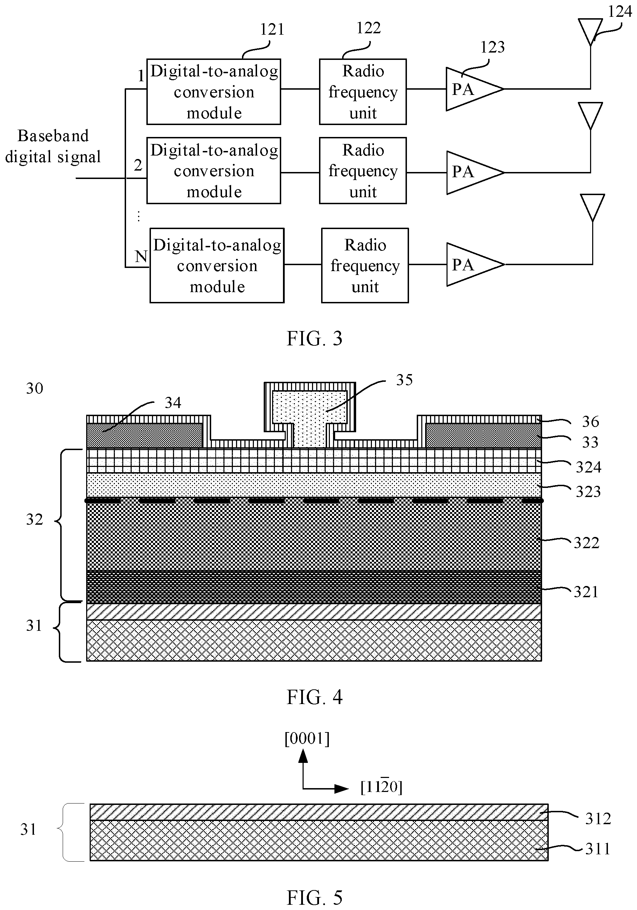

For example, the electronic device provided in embodiments of this application is a 5G base station. The 5G base station may be divided into different architectures such as a baseband processing unit (baseband unit, BBU) - an active antenna unit (active antenna unit, AAU), a centralized unit - a distributed unit (central unit-distribute unit, CU-DU) - an AAU, a BBU - a remote radio unit (remote radio unit, RRU) - an antenna (antenna), a CU - a DU - an RRU - an antenna, and an integrated 5G base station (5G node base station, gNB). A base station of the BBU-AAU architecture is used as an example. As shown in FIG. 2, the base station includes a BBU 11 and an AAU 12. The BBU 11 transmits a generated baseband digital signal by using the AAU 12. As shown in FIG. 3, the AAU includes a digital-to-analog conversion module 121 (for example, may be a DAC (digital to analog converter, digital to analog converter)), a radio frequency unit 122, and a power amplifier 123 (power amplifier, PA), and an antenna 124. The digital-to-analog conversion module 121 is configured to convert a baseband digital signal output by a baseband processing unit into an analog signal. The radio frequency unit 122 is configured to convert the analog signal into a low-power radio frequency signal. The power amplifier 123 is configured to amplify power of the low-power radio frequency signal and output the radio frequency signal to the antenna 124 for external radiation. The AAU shown in FIG. 3 includes n antennas 124, and each antenna 124 corresponds to a group of the digital-to-analog conversion module 121, the radio frequency unit 122, and the power amplifier 123. Certainly, this embodiment of this application is not limited to the base station shown in FIG. 2 and FIG. 3. It may be understood that any electronic device that needs to amplify a signal by using the power amplifier belongs to an application scenario of this embodiment of this application.

As shown in FIG. 4, an embodiment of this application provides a power amplification component 30 (the power amplification component 30 may be the power amplifier 123 in FIG. 3), and the power amplification component 30 mainly includes a substrate 31 and an epitaxial structure 32 that is of a transistor and that is fabricated on the substrate 31. The epitaxial structure 32 mainly includes a nucleation layer 321, a buffer layer 322, an insertion layer 323, and a barrier layer 324 that are disposed on the substrate 31. Electrodes such as a gate 35, a source 33, and a drain 34 are disposed on the epitaxial structure 32. A passivation layer 36 is covered on the electrode. For example, the transistor is a high-electron-mobility transistor (high electron mobility transistor, HEMT). The nucleation layer 321 in the epitaxial structure 32 generally uses an aluminum nitride (AlN) material, the buffer layer 322 generally uses a GaN material, the insertion layer 323 generally uses the aluminum nitride (AlN) material, the barrier layer 324 generally uses an aluminum gallium nitrogen (AlGaN) material, and the electrode generally uses a metal material. The source 33 and the drain 34 separately form conductive ohmic contact with the barrier layer 324, and the gate 35 forms Schottky contact with the barrier layer 324. A dashed line in the buffer layer 322 represents two-dimensional electron gas (two-dimensional electron gas, 2DEG) generated in a heterostructure formed by the buffer layer 322 and the barrier layer 324 in the HEMT. Mobility of the two-dimensional electron gas in a plane direction (the dashed line in the buffer layer 322 in FIG. 3) is extremely high, and is a basis for operation of the HEMT. The insertion layer 323 serves to improve density, a localization degree, and mobility of the two-dimensional electron gas, to improve performance of the component, for example, obtain excellent switching performance. Therefore, the insertion layer 323 is an optional structure. When the insertion layer 323 is not disposed in the HEMT, the performance of the component decreases. In addition, the nucleation layer 321 is also an optional structure, and the nucleation layer 321 is mainly used as a transition function when crystal structures of materials of the buffer layer 322 and the substrate 31 differ to a relatively large extent. For example, when the crystal structures of the materials of the buffer layer 322 and the substrate 31 differ to a relatively large extent, the nucleation layer 321 with a relatively small difference from the crystal structure of the substrate 31 may be first epitaxially generated on the substrate, and then the buffer layer 322 is epitaxially formed on the nucleation layer 32.

In this embodiment of this application, the substrate 31 uses a composite substrate. As shown in FIG. 5, the substrate 31 includes a base 311 and a first epitaxial layer 312 formed on the base 311, and the first epitaxial layer 312 is a semiconductor. The base 311 and the first epitaxial layer 312 include a SiC material. The first epitaxial layer 312 is doped with transition metal, and the base 311 is doped with an impurity that provides a carrier.

In an implementation, a 4H (4-hexagonal, 4-layer carbon-silicon atomic hexagonal crystal system) structure is mainly used for a unit cell of a SiC crystal formed by using the SiC material in the first epitaxial layer 312 and the base 311. Resistivity of the first epitaxial layer 312 is greater than resistivity of the base. Specifically, the base may use a conductive SiC material. For example, the resistivity of the base 311 is less than 0.03 Ω·cm, thickness of the base 311 is 350 µm ± 25 µm, and a diameter is 100 mm, 150 mm, or 200 mm. The first epitaxial layer 312 is mainly implemented by doping the transition metal in a homogeneous epitaxial growth process through chemical vapor deposition (chemical vapor deposition, CVD), and the transition metal includes vanadium V or iron Fe. When the transition metal vanadium V is doped, a proper amount of reactant gas (such as VCl₄) of a vanadium compound is specifically injected in the epitaxial growth process, so that the vanadium is doped. A vanadium impurity in the SiC crystal can be used as a compensation center of a deep energy level, and can compensate for unintentionally doped nitrogen N and boron B in the SiC crystal, to implement a semi-insulator characteristic of the first epitaxial layer 312. Doping concentration of transition metal in the first epitaxial layer 312 is 1e14 cm^-3 to 1e17 cm^-3, the resistivity of the first epitaxial layer 312 is greater than 1e5 Q cm, and thickness of the first epitaxial layer 312 is 1 µm to 100 µm. In addition, it should be noted that, when the transition metal iron is doped, a proper amount of reactant gas (such as tert-Butylferrocene C₁₄H₁₇Fe) of an iron compound is specifically injected in the epitaxial growth process, so that the iron is doped.

A process of forming the base is mainly as follows: silicon carbide powder is used, high-temperature sublimation is performed by using a PVT method to obtain a SiC crystal, and then wire cutting is performed on the SiC crystal to obtain the base. When a requirement on the resistivity of the base is relatively low, requirements on purity and doping of the silicon carbide powder are relatively low in a process of fabricating the base. For example, the base uses an N-type substrate (doped with an N-type element) with relatively low fabrication costs. In this way, when the SiC powder is used to form the SiC crystal, there is no need to entirely isolate air, and no requirement is imposed on unintentionally doped nitrogen N, aluminum Al, boron B, and the like in a production process.

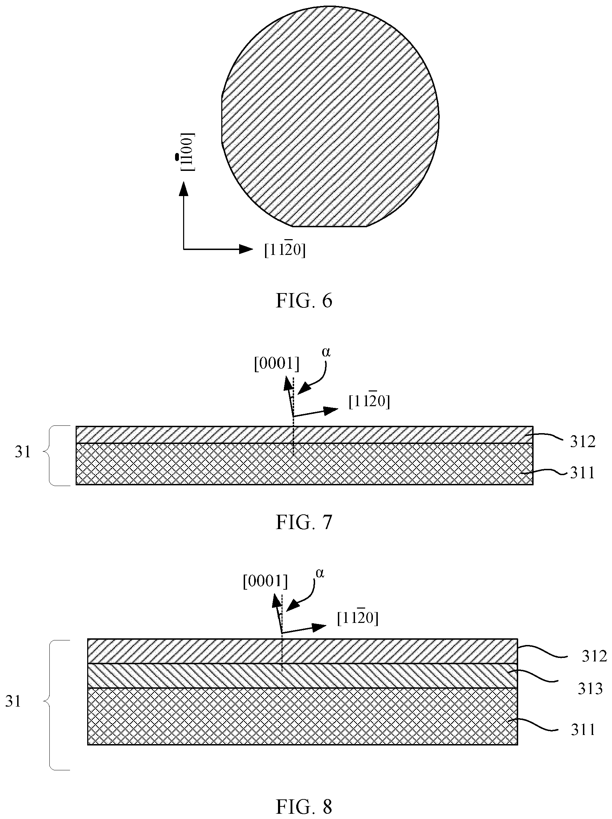

In addition, with reference to FIG. 5 and FIG. 6, because the first epitaxial layer 312 is formed by being directly epitaxially grew on the base, the first epitaxial layer 312 maintains a same direction as the SiC crystal in the base 311. As shown in FIG. 5, a vertical surface of the substrate 31 uses a crystal axial direction [0001] of the SiC crystal or a direction close to the crystal axial direction [0001], such as a crystal off-angle α (0 to 4 degrees) (as shown in FIG. 7). As shown in FIG. 5 and FIG. 6, on a horizontal surface of the substrate 31, a primary orientation flat (primary orientation flat) is a direction [112̅0] (also referred to as a long cutting edge), and a secondary orientation flat (secondary orientation flat) is a direction [11̅00] (also referred to as a secondary orientation flat). In addition, a ratio of a length of the primary orientation flat to a length of the secondary orientation flat is generally less than 2. For example, the length of the primary orientation flat is 32.5 mm, and the length of the secondary orientation flat is 18 mm.

In the foregoing solution, the substrate may use at least two layers of materials, that is, the base and the first epitaxial layer. The base mainly uses the SiC material and is doped with the impurity that provides the carrier, and the first epitaxial layer uses a SiC material doped with the transition metal. In this way, because the first epitaxial layer uses the SiC material doped with the transition metal, and impurity compensation is performed on the SiC material by using the transition metal, the resistivity of the first epitaxial layer can be improved, so that the first epitaxial layer has a semi-insulator characteristic, and a fabrication requirement on an epitaxial structure is met. Because the epitaxial structure is not directly fabricated on the base, a requirement on the base is reduced in this embodiment of this application. Therefore, dependence of the transistor on a silicon carbide substrate in an intrinsic state is reduced, and costs are effectively controlled. For example, in this embodiment of this application, the SiC material is used to form the base, and a silicon carbide material doped with the transition metal is used to form the first epitaxial layer with the semi-insulator characteristic. Compared with a conventional technology in which only the silicon carbide material is used to form the silicon carbide substrate in the intrinsic state, the substrate in this application uses a form of a composite substrate with the base and the first epitaxial layer, so that a quantity of used silicon carbide materials in the intrinsic state can be reduced. The base may use a conductive silicon carbide material doped with the impurity that can provide the carrier. In this way, a requirement on a growth process is much lower than that of the silicon carbide substrate in the intrinsic state. For example, the base may be a conductive SiC material (that is, doped with the impurity that can provide the carrier). In this way, the resistivity of the first epitaxial layer is greater than the resistivity of the base. Because a resistivity requirement on the base is relatively low, requirements on purity and doping of silicon carbide powder are relatively low in a process of fabricating the base. For example, the base uses an N-type substrate (doped with an N-type element) with relatively low fabrication costs. In this way, when SiC powder is used to form a SiC crystal, there is no need to entirely isolate air, and no requirement is imposed on impurities such as nitrogen N, aluminum Al, and boron B that can provide the carrier and that are introduced in a production process due to unintentional doping.

In an implementation, the substrate 31 may use a manner in which there are a plurality of epitaxial layers on the base 311. As shown in FIG. 8, a second epitaxial layer 313 is included between the first epitaxial layer 312 and the base 311, and the second epitaxial layer 313 includes the SiC material. The second epitaxial layer and the base are formed by using different processing processes. When the second epitaxial layer is included between the first epitaxial layer and the base, thickness of the first epitaxial layer can be reduced as much as possible. A requirement on the second epitaxial layer is similar to that on the base, so that a quantity of used silicon carbide materials in the intrinsic state can be further reduced. The second epitaxial layer may use a conductive silicon carbide material or a silicon carbide material with the semi-insulator characteristic. Resistivity of the second epitaxial layer may be equal to the resistivity of the base. For example, the resistivity of the second epitaxial layer is less than 0.03 Q cm. When two or more epitaxial layers are used, the transition metal needs to be doped only on a top epitaxial layer (such as the first epitaxial layer 313) to form a semiconductor, and an epitaxial layer (such as the second epitaxial layer) in the middle uses a conductive epitaxial layer. In this way, the thickness of the first epitaxial layer can be reduced as much as possible. For example, the thickness of the first epitaxial layer is 1 µm to 50 µm, and thickness of the second epitaxial layer is 1 µm to 50 µm. Therefore, a sum of thickness of the base, the thickness of the first epitaxial layer, and the thickness of the second epitaxial layer is basically equivalent to that of the substrate shown in FIG. 3. However, because only the first epitaxial layer needs to be doped, an amount of transition metal used during doping is reduced, and occurrence of a crystal defect and a crystal polytype problem is also reduced. In addition, the resistivity of the second epitaxial layer is greater than the resistivity of the base and less than the resistivity of the first epitaxial layer. For example, the resistivity of the second epitaxial layer may also be greater than or equal to 0.03 Ω·cm and less than 1e5 Ω·cm. In this way, gradual transition from the resistivity of the base to the resistivity of the first epitaxial layer can be implemented. The second epitaxial layer may be a silicon carbide material that has the semi-insulator characteristic and that is formed by doping the transition metal (such as vanadium V or iron Fe) by using reactant gas in an epitaxial growth process. In addition, the resistivity may be adjusted by controlling doping concentration of the transition metal. In this way, when the doping concentration of the transition metal of the second epitaxial layer is less than that of the first epitaxial layer, the resistivity of the second epitaxial layer is less than the resistivity of the first epitaxial layer. In this way, occurrence of a crystal defect and a crystal polytype problem that are caused by an excessively large material property difference when the first epitaxial layer is directly fabricated on the base can also be avoided. In addition, the resistivity of the second epitaxial layer may also be adjusted by controlling a Si vacancy and/or a C vacancy in an epitaxy process of SiC, and the Si vacancy and/or the C vacancy may be adjusted by controlling a ratio of a C atom to a Si atom in gas used for epitaxy of the second epitaxial layer. In this embodiment, a unit cell of a SiC crystal formed by using the SiC material of the second epitaxial layer 313 mainly uses a 4H structure. Certainly, more epitaxial layers may alternatively be included between the first epitaxial layer and the base. Certainly, when more epitaxial layers are used, structures of these epitaxial layers are the same as a structure of the second epitaxial layer. In addition, the second epitaxial layer and the base are formed by using different processing processes. For example, the base mainly grows by using silicon carbide powder by using a physical vapor transport PVT method, to obtain the SiC crystal, and then, processing such as wire cutting, grinding, and polishing is performed on the SiC crystal to obtain the base. Because the base may use a conductive base, requirements on purity of the silicon carbide powder and process complexity of the PVT are relatively low. Then, the second epitaxial layer is epitaxially formed on the base through high-temperature chemical vapor deposition (CVD).

In an implementation, an embodiment of this application provides a fabrication method for a substrate, and the fabrication method includes the following steps.

101: Perform surface processing on a surface of a base.

Surface roughness of the base is ≤ 0.5 nm after surface processing. The surface processing includes one or more of cutting processing, grinding processing, and grinding and mechanical polishing processing. The base mainly grows by using silicon carbide powder by using a physical vapor transport PVT method, to obtain a SiC crystal, and then, processing such as wire cutting, grinding, and polishing is performed on the SiC crystal to obtain the base. Because the base may use a conductive base (for example, the base is doped with an impurity that provides a carrier), requirements on purity of the silicon carbide powder and process complexity of the PVT are relatively low.

102: Fabricate a first epitaxial layer on the base, where the base and the first epitaxial layer include a SiC material, the first epitaxial layer is doped with transition metal, and the first epitaxial layer is a semiconductor.

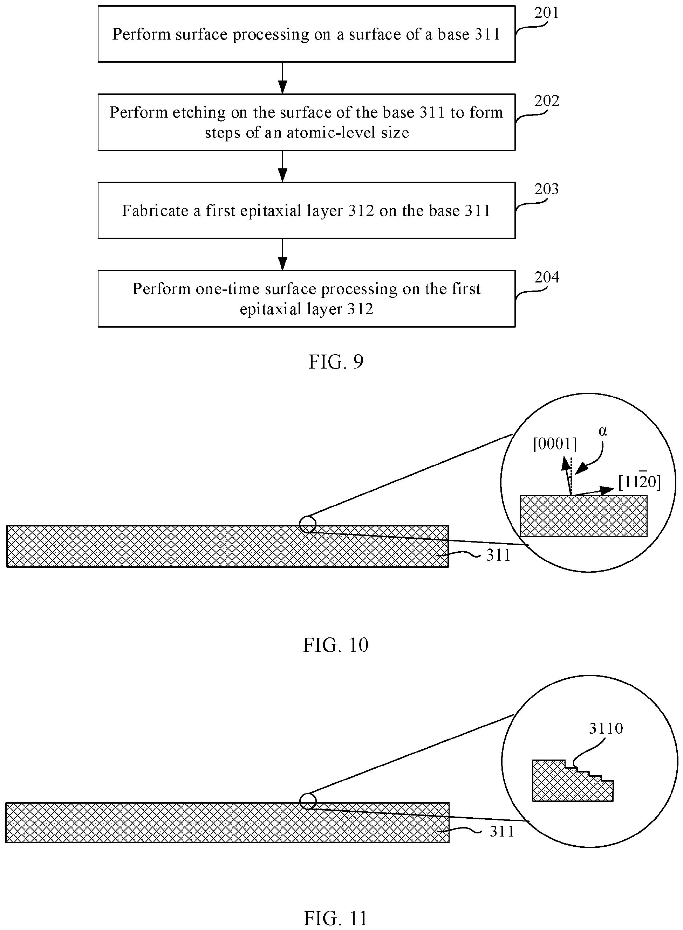

Specifically, in an implementation, when the substrate shown in FIG. 5 is fabricated, as shown in FIG. 9, the following steps are specifically included.

201: Perform surface processing on a surface of the base 311.

In this embodiment of this application, the base 311 uses a conductive material, and the base 311 includes the SiC material. For example, the SiC material in the base may be a SiC crystal whose unit cell mainly uses a 4H (4-hexagonal, 4-layer carbon-silicon atomic hexagonal crystal system) structure. Resistivity of the base 311 is less than 0.03 Ω·cm, thickness of the base 311 is 350 µm ± 25 µm, and a diameter is 100 mm, 150 mm, or 200 mm. As shown in FIG. 10, referring to a partially enlarged view of the surface of the base 311, a vertical surface of the base 311 uses a crystal axial direction [0001] of the SiC crystal or a direction close to the crystal axial direction [0001], such as a crystal off-angle α (0 to 4 degrees).

202: Perform etching on the surface of the base 311 to form steps of an atomic-level size.

In step 202, the surface of the base 311 is further etched by using an etching process, to obtain steps 3110 of the atomic-level size. As shown in FIG. 11, in a partially enlarged schematic diagram of the steps 3110, width of the steps 3110 is generally 1 nm to 3 µm, and height of the steps 3110 is generally 0.25 nm to 2 nm. In this step, in the etching process, hydrogen H₂ is used for etching, etching temperature ranges from 1500°C to 1700°C, and etching time ranges from 10 minutes to 200 minutes. The steps of the atomic-level size fabricated in step 202 are used to adjust impact of the crystal off-angle α on fabricating the first epitaxial layer. For example, as shown in FIG. 10, when there is a leftward crystal off-angle α on the vertical surface of the base 311, the steps shown in FIG. 11 extend from left to right, and when there is a rightward crystal off-angle α on the vertical surface of the base 311, the steps extend from the right to the left. In addition, the steps may be continuously distributed on the surface of the base 311, or periodically distributed on the surface of the base 311. Therefore, step 202 may be omitted when the crystal axial direction [0001] of the SiC crystal is used on the vertical surface of the base 311.

203: Fabricate a first epitaxial layer 312 on the base 311.

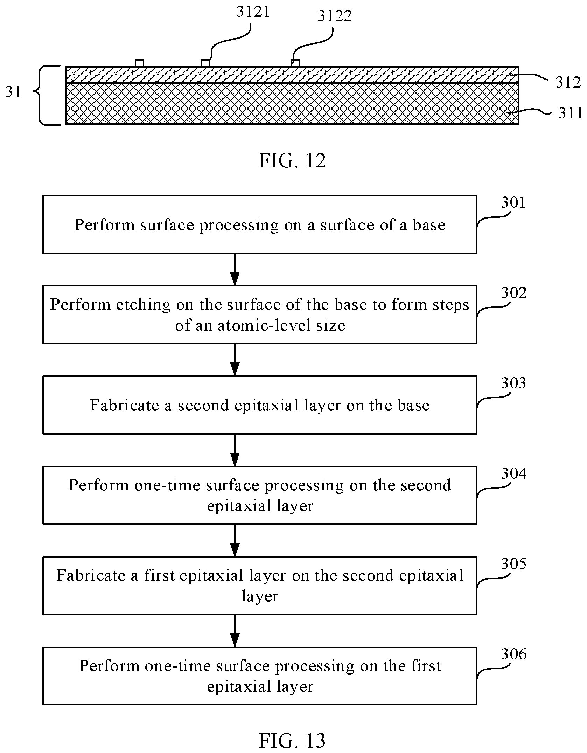

The first epitaxial layer 312 includes the SiC material, and the first epitaxial layer 312 is doped with transition metal. In step 203, the first epitaxial layer 312 is specifically epitaxially formed on the base by using a chemical vapor deposition process, as shown in FIG. 12. After surface etching on the base is completed, homogeneous epitaxy of a conductive SiC base is performed (in other words, the first epitaxial layer and the base use a same SiC material). Epitaxial growth is completed in a high-temperature chemical vapor deposition (CVD) device, temperature for epitaxial growth is 1400°C to 1700°C, and gas used for epitaxial growth mainly includes silane SiH₄, propane C₃H₈, HCl, H₂, VCl₄, and the like. Silane SiH₄ and propane C₃H₈ are mainly used to react to obtain SiC, vanadium tetrachloride VCl₄ gas mainly provides transition metal, that is, an element V, used for doping, H₂ is carrier gas, and HCl is used as a growth additive and a main function is to increase a growth speed of a silicon carbide epitaxial layer. The first epitaxial layer is obtained by being doped with the element V, and resistivity of the first epitaxial layer is greater than 1e5 Q cm. Generally, doping concentration of V ranges from 1e14 cm^-3 to 1e17 cm^-3. Thickness of the first epitaxial layer is generally 10 µm to 100 µm. An epitaxial crystal structure in which 4H-SiC (a SiC crystal of a 4H-structure) is dominant can be obtained by adjusting proportions of different gas, a flow rate, and a growth process condition. Generally, an etching process in step 202 and an epitaxy process in step 203 are completed in a same CVD device, to ensure that the etched base is not twice contaminated. In addition, in step 203, if the first epitaxial layer is doped by using the transition metal, that is, an element iron, a specific proportion of tert-Butylferrocene (C₁₄H₁₇Fe) gas is injected in a CVD process to replace vanadium tetrachloride VCl₄ gas, so that silicon carbide is doped.

204: Perform one-time surface processing on the first epitaxial layer 312.

In a process of epitaxially forming the first epitaxial layer on the base, due to instability of a process, impurities and defects easily occur. For example, a vanadium compound reacts with gas used for epitaxy of silicon carbide to form an intermediate product or a precipitate or to generate another crystalline form (such as a 3C-SiC crystalline form, a 3-cubic, or a three-layer carbon-silicon atomic cubic crystal system), and consequently, an impurity or a micro-defect is caused. One-step surface processing (such as grinding processing, polishing processing, and cutting processing) needs to be performed to remove some impurities 3121 and micro-defects 3122 on a surface of the first epitaxial layer, so that surface roughness of the first epitaxial layer is less than 0.5 nm. Finally, the substrate shown in FIG. 5 is obtained.

In this case, an epitaxial structure 32 (as shown in FIG. 4) of a transistor may continue to be epitaxially formed on the substrate by using the CVD process. An electrode for forming the transistor is then obtained by using a component processing process, to form the transistor.

Specifically, in an implementation, when the substrate described in FIG. 8 is fabricated, as shown in FIG. 13, the following steps are specifically included.

301: Perform surface processing on a surface of a base.

For details of step 301, refer to a fabrication process in step 201. Details are not specifically described again.

302: Perform etching on the surface of the base to form steps of an atomic-level size.

For details of step 302, refer to a fabrication process in step 202. Details are not specifically described again.

303: Fabricate a second epitaxial layer on the base.

The second epitaxial layer includes a SiC material. In step 303, the second epitaxial layer is specifically epitaxially formed on the base by using a chemical vapor deposition process. After surface etching on the base is completed, homogeneous epitaxy of a conductive SiC base is performed (in other words, the second epitaxial layer and the base use a same SiC material). Epitaxial growth is completed in a high-temperature chemical vapor deposition (CVD) device, temperature for epitaxial growth is 1400°C to 1700°C, and gas used for epitaxial growth mainly includes silane SiH₄, propane C₃H₈, HCl, H₂, and the like. Silane SiH₄ and propane C₃H₈ are mainly used to react to obtain SiC.

Resistivity of the second epitaxial layer is less than 0.03 Ω·cm. An epitaxial crystal structure in which 4H-SiC (a SiC crystal of a 4H-structure) is dominant can be obtained by adjusting proportions of different gas, a flow rate, and a growth process condition. In step 303, the transition metal (such as vanadium V or iron Fe) may be doped by using reactant gas in an epitaxial growth of the second epitaxial layer, and the resistivity may be adjusted by controlling doping concentration of the transition metal. Alternatively, a Si vacancy in an epitaxial process of SiC is controlled to adjust the resistivity of the second epitaxial layer. Generally, an etching process in step 302 and an epitaxy process in step 303 are completed in a same CVD device, to ensure that the etched base is not twice contaminated.

304: Perform one-time surface processing on the second epitaxial layer.

In a process of epitaxially forming the second epitaxial layer on the base, due to instability of a process, impurities and defects easily occur. For example, another crystalline form (such as a 3C-SiC crystalline form) is generated, and consequently, an impurity or a micro-defect is caused. One-step surface processing (such as grinding processing, polishing processing, and cutting processing) needs to be performed to remove some impurities and micro-defects on a surface of the second epitaxial layer, so that surface roughness of the second epitaxial layer is less than 0.5 nm. Certainly, if after step 303, the roughness of the surface of the second epitaxial layer can meet a requirement for fabricating a first epitaxial layer in a next step, step 304 may be omitted.

305: Fabricate the first epitaxial layer on the second epitaxial layer.

Homogeneous epitaxy is also used in a process of fabricating the first epitaxial layer on the second epitaxial layer. Therefore, this process is the same as a manner of fabricating the first epitaxial layer on the base. For details, refer to step 204. Details are not described again.

306: Perform one-time surface processing on the first epitaxial layer.

For details of step 306, refer to a fabrication process in step 204. Details are not specifically described again.

In this case, an epitaxial structure 32 (as shown in FIG. 4) of a transistor may continue to be epitaxially formed on the substrate through CVD. An electrode for forming the transistor is then obtained by using a component processing process, to form the transistor.

According to another aspect of this application, a non-transitory computer readable storage medium to be used together with a computer is further provided. The computer has software used to design an integrated circuit, the computer readable storage medium stores one or more computer readable data structures, and a process device fabricates the foregoing provided substrate by using the one or more computer readable data structures.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A substrate, used in a transistor, wherein an epitaxial structure of the transistor is generated on the substrate, the substrate comprises a base and a first epitaxial layer formed on the base, and the first epitaxial layer is a semiconductor;
the base and the first epitaxial layer comprise a SiC material; and
the first epitaxial layer is doped with transition metal, and the base is doped with an impurity that provides a carrier.

2. The substrate according to claim 1, wherein a second epitaxial layer is comprised between the first epitaxial layer and the base, the second epitaxial layer comprises the SiC material, and the second epitaxial layer and the base are formed by using different processing processes.

3. The substrate according to claim 1 or 2, wherein resistivity of the first epitaxial layer is greater than resistivity of the base.

4. The substrate according to claim 2, wherein resistivity of the second epitaxial layer is greater than resistivity of the base, and the resistivity of the second epitaxial layer is less than resistivity of the first epitaxial layer

5. The substrate according to any one of claims 1 to 4, wherein the transition metal comprises vanadium V or iron Fe.

6. The substrate according to any one of claims 1 to 5, wherein doping concentration of transition metal in the first epitaxial layer is 1e14 cm^-3 to 1e17 cm^-3.

7. The substrate according to any one of claims 1 to 6, wherein the resistivity of the base is less than 0.03 Q cm.

8. The substrate according to any one of claims 1 to 7, wherein the resistivity of the first epitaxial layer is greater than 1e5 Q cm.

9. The substrate according to claim 2, wherein the resistivity of the second epitaxial layer is less than 0.03 Q cm.

10. The substrate according to any one of claims 1 to 9, wherein a unit cell of the SiC material uses a 4H structure.

11. A fabrication method for a substrate, wherein the substrate is used in a transistor, an epitaxial structure of the transistor is generated on the substrate, and the fabrication method comprises:
performing surface processing on a surface of the base; and
fabricating a first epitaxial layer on the base, wherein the base and the first epitaxial layer comprise a SiC material, the first epitaxial layer is doped with transition metal, the first epitaxial layer is a semiconductor, and the base is doped with an impurity that provides a carrier.

12. The fabrication method for a substrate according to claim 11, wherein before the fabricating a first epitaxial layer on the base, further comprises: fabricating a second epitaxial layer on the base, wherein the second epitaxial layer comprises the SiC material.

13. The fabrication method for a substrate according to claim 11 or 12, wherein the surface processing comprises one or more of cutting processing, grinding processing, and polishing processing.

14. The fabrication method for a substrate according to any one of claims 11 to 13, wherein after the performing surface processing on a surface of the base, further comprises:
performing etching on the surface of the base to form steps of an atomic-level size.

15. The fabrication method for a substrate according to any one of claims 11 to 14, wherein the fabricating a first epitaxial layer on the base comprises:
epitaxially forming the first epitaxial layer on the base by using a chemical vapor deposition process.

16. The fabrication method for a substrate according to claim 15, wherein gas used in the chemical vapor deposition process comprises silane SiH₄, propane C₃H₈, and a transition metal compound.

17. The fabrication method for a substrate according to claim 16, wherein the transition metal compound comprises vanadium tetrachloride VCL₄ or tert-Butylferrocene C₁₄H₁₇Fe.

18. A power amplification component, comprising a substrate and an epitaxial structure that is of a transistor and that is formed on the substrate, wherein the substrate comprises the substrate according to any one of claims 1 to 10.

19. The power amplification component according to claim 18, wherein the epitaxial structure comprises a buffer layer disposed on the first epitaxial layer and a barrier layer disposed on the buffer layer, and there is an electrode on the barrier layer.

20. The power amplification component according to claim 19, wherein the epitaxial structure further comprises a nucleation layer disposed between the first epitaxial layer and the buffer layer

21. The power amplification component according to claim 19, wherein the epitaxial structure further comprises an insertion layer disposed between the buffer layer and the barrier layer

22. An electronic device, comprising a power amplification component and an antenna, wherein the power amplification component is configured to amplify a radio frequency signal and output the radio frequency signal to the antenna for external radiation, and the power amplification component comprises the power amplification component according to any one of claims 18 to 21.
